Europäisches Patentamt

European Patent Office

Office européen des brevets

(11) Publication number: **0 547 677 A2**

# EUROPEAN PATENT APPLICATION

(21) Application number: **92203826.0**

(22) Date of filing: **09.12.92**

(51) Int. Cl.5: **H01L 21/76, H01L 21/306**

(30) Priority: **17.12.91 US 809465**

(43) Date of publication of application:
**23.06.93 Bulletin 93/25**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Arst, Margareth, c/o**
**Int.Octrooibureau B.V.**
**Prof. Holstlaan 6**
**NL-5656 AA Eindhoven(NL)**

(74) Representative: **Veerman, Jan Willem et al**
**INTERNATIONAAL OCTROOIBUREAU B.V.**
**Prof. Holstlaan 6**
**NL-5656 AA Eindhoven (NL)**

(54) **Use of vapor-phase etching in fabrication of semiconductor-on-insulator structure.**

(57) A semiconductor-on-insulator structure is fabricated from an initial structure in which a primary wafer-like semiconductive body (20) having a largely flat upper surface (26) and a typical thickness of 2 microns or more adjoins an insulating layer (24) of an underlying supporting substructure (22, 24, and 28). The fabrication involves performing a vapor-phase etch, preferably with gaseous hydrochloric acid, on the primary body to lower the upper surface while keeping it largely flat. The thickness of the primary body is thereby reduced to a value typically less than 2 microns -- e.g., 1 micron.

FIG.2

This invention relates to the manufacture of structures from which semiconductor integrated circuits ("ICs") can be fabricated. In particular, this invention relates to the fabrication of semiconductor-on-insulator structures, especially those of the silicon-on-insulator ("SOI") type.

A planar IC can be created from a number of different kinds of starting structures. In each of these starting structures, a mechanism usually must be provided to enable certain circuit elements in the semiconductor material to be electrically isolated from other circuit elements in the semiconductor material.

Considerable interest is currently being focused on the SOI starting structure in which a principal flat monocrystalline silicon ("monosilicon") layer adjoins an electrically insulating layer of a substructure having sufficient mass and mechanical strength to support the silicon layer during normal handling and IC fabrication operations. The silicon layer is typically 2 - 3 microns in thickness. Because this is quite thin, the requisite mechanism for isolating circuit elements in the Si layer can sometimes be created by simply forming a (web-like) dielectric region that extends all the way through the Si layer down to the insulating layer. There is no need to use reverse-biased PN junctions to help complete the isolation. Since the electrical isolation is fully dielectric, the SOI structure is especially attractive for high-speed radiation-hardened applications.

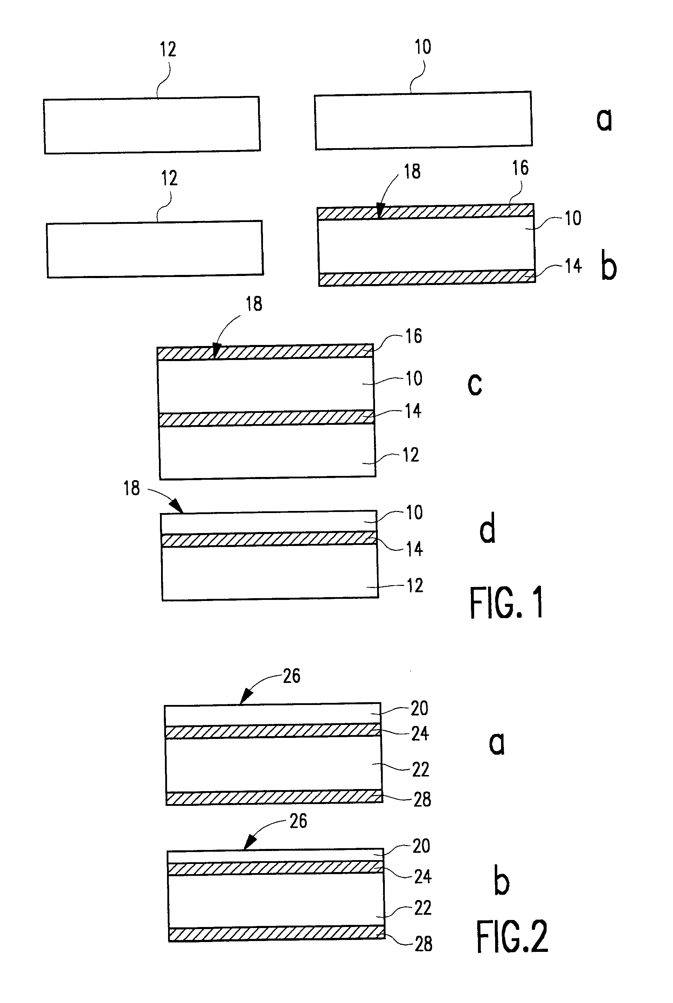

Abe et al, "Silicon Wafer-bonding Process Technology for SOI Structures", Procs. 4th Int'l Symp. SOI Techn. & Dev., 8 - 11 May 1990, pp. 61 - 71, describe a technique of a conventional type for making an SOI structure. Turning to the drawings, Figs 1a - 1d generally illustrate how Abe et al create their SOI structure. With reference to Fig. 1a, Abe et al begin with a pair of monocrystalline silicon semiconductive wafers 10 and 12, each having substantially flat upper and lower surfaces. Both of wafers 10 and 12 have a relatively uniform thickness of 625 microns. Wafer 10 is referred to as the "primary" wafer since a thinned portion is later typically provided with electronic circuit elements. Wafer 12 is referred to as the "base" wafer because it later furnishes the major structural support for the thinned portion of primary wafer 10.

The first step in the SOI fabrication process of Abe et al entails thermally growing electrically insulating layers 14 and 16 of silicon dioxide to a thickness of 1 micron along the respective lower and upper surfaces of wafer 10. See Fig. 1b. Item 18 indicates the substantially flat upper surface of primary wafer 10 at the interface with oxide layer 16. Next, primary wafer 10 is bonded to base wafer 12 along oxide layer 14 as indicated in Fig. 1c.

A conventional thinning operation is then performed by grinding and mechanical/liquid-chemical polishing to remove oxide layer 16 and to lower upper surface 18 while keeping upper surface 18 largely flat. In this thinning operation, all of wafer 10 is removed except for a thin portion having a relatively uniform thickness of 2 - 3 microns. Fig. 1d shows the resulting SOI structure in which inter-wafer oxide layer 14 is the insulating layer, and the remaining thinned portion of primary wafer 10 is the principal silicon layer. Electronic circuit elements and a dielectric isolation region can now be provided in the principal Si layer.

Abe et al indicate that the final thickness of silicon layer 10 can only be controlled to about ±0.5 micron of the desired final value. As a result, Si layer 10 cannot be made significantly thinner than 2 microns without materially damaging the performance and reliability of ICs formed out of the SOI structure. While many dielectric isolation mechanisms can penetrate through a 2-micron Si layer, certain highly desirable dielectric isolation mechanisms, such as the LOCOS mechanism used for metal-oxide-semiconductor ("MOS") type ICs, cannot penetrate through a 2-micron Si layer without causing severe loss in circuit element density. Thus, LOCOS cannot readily be employed in fabricating MOS-type ICs from the SOI structure of Abe et al.

Techniques for reducing the thickness of the primary wafer in a bonded-wafer SOI structure of the type generally shown in Fig. 2c to a thickness of 1 micron or less have been reported in the published literature. For example, see Palkuti et al, "Radiation Response of CMOS/SOI Devices Formed by Wafer Pond and Etchback", IEEE Trans. Nucl. Sci., Dec. 1988, pp. 1653 - 1656. Also see Matsu et al, Japanese Patent Publication 2-1914.

Palkuti et al specify that the primary wafer is thinned by a conventional grinding/mechanical-polishing technique followed by a (so-called) "non-contact polish" step. Palkuti et al indicate that the non-contact polishing is a bromine-based chemical process that removes silicon in a uniform manner without actual pad contact. Palkuti et al do not go into further detail about this step. Nonetheless, it appears to be a liquid-chemical etching technique since bromine is liquidous at room temperature. After the bromine-based polish step, Palkuti et al further thin the primary wafer by thermally growing a silicon-dioxide layer along the outer silicon surface and then removing the just-grown oxide.

The thinning procedure described in Palkuti et al may be capable of producing an SOI structure with a high-quality silicon layer having a thickness of 1 micron or slightly less so that the structure is suitable for LOCOS. However, a liquid-chemical etch process such as the bromine-based polish step is usually quite sensitive to changes in temperature and to changes in solution composition. Achieving acceptable control over the Si etch rate from wafer to wafer during volume production would probably be difficult with the bromine-based polish. Because Palkuti et al finish their thinning process with an oxide growth/removal procedure, the process is also relatively complex.

In Matsu et al, an etch stop is provided in the primary wafer at a location spaced apart from the inter-wafer insulating layer by a distance approximately equal to the desired final thickness of the silicon layer. The etch stop is an impurity-containing layer created by implanting an impurity such as oxygen, into the primary wafer and then annealing the wafer. In thinning the primary wafer, the silicon above the etch stop is first removed with a liquid-chemical etchant. When the etchant reaches the etch stop, the etch rate drops greatly, thereby indicating completion of the etch. A plasma etch or a mechanical/liquid-chemical polishing technique is subsequently employed to remove the etch stop.

The thinning technique used in Matsu et al is quite complicated. Achieving acceptable uniformity across each wafer during volume production would probably be difficult with their thinning procedure. In addition, the principal silicon layer is likely to have a high defect density due to the impurity implanted in creating the etch stop. It would be highly desirable to have a simple, accurate, and easily controllable technique for performing a thinning operation on a structure such as that of the bonded-wafer type to produce a high-quality SOI structure whose principal silicon layer has a thickness of 1 micron or less.

The present invention furnishes such a thinning technique.

More specifically, in accordance with the invention, a semiconductor-on-insulatorstructure is created from an initial structure in which a primary wafer-like semiconductive body adjoins an insulating layer of a substructure having sufficient mass and mechanical strength to support the primary semiconductive body during normal handling and semiconductor device fabrication operations. The primary body has a largely flat major surface situated opposite the insulating layer. Also, the primary body normally has a substantially uniform initial thickness of 2 microns or slightly more --e.g., 3 microns.

The invention is characterized in that a vapor-phase etch is performed on the primary body to thin it and lower the major surface while keeping the major surface largely flat. As used here, the expression "vapor-phase etch" means a (non-plasma) chemical etch done with an etchant in the gaseous state. When the primary body consists principally of monosilicon so that the structure is an SOI structure, the vapor-phase etch is preferably done with gaseous hydrochloric acid using hydrogen as carrier gas. The etch rate is 0.01 - 0.30 micron/minute, preferably 0.07 0- 0.15 micron/minute. This allows the etch to be performed with good timing control.

At the end of the vapor-phase etch, the thickness of the primary body normally reaches a substantially uniform value less than 2 microns -- e.g., 1 micron. The final semiconductor-on-insulator structure is thus particularly suitable for MOS-type applications that utilize LOCOS for lateral electrical isolation.

The vapor-phase etch is done without using an etch stop situated in the initial structure. Consequently, the invention avoids the complexities and attendant disadvantages of prior art thinning techniques, such as that of Matsu et al, which utilize etch stops physically located in the principal silicon layer.

The present vapor-phase etch does not pose any significant control problems for volume production. In particular, the etch is easily controlled within acceptable limits from wafer to wafer, especially when done with gaseous hydrochloric acid, a common IC fabrication chemical. The invention is also readily susceptible to batch processing in which the vapor-phase etch is simultaneously performed on a group of the initial structures placed in a suitable reaction chamber.

Figs. 1a, 1b, 1c and 1d illustrate steps in a prior art method for creating an SOI structure whose principal silicon layer has a thickness of 2 - 3 microns.

Figs. 2a and 2b illustrate steps in a method according to the invention for creating an SOI structure whose principal silicon layer has a thickness of 1 micron or less.

Like reference symbols are employed in the drawings and in the description of the preferred embodiments to represent the same or very similar item or items.

Referring to Figs. 2a and 2b, they illustrate how an SOI structure having a very thin principal silicon layer is created according to the teachings of the invention.

As shown in Fig. 2a, the starting point is a structure in which a primary monosilicon semiconductive wafer-like body 20 and a base monosilicon semiconductive wafer 22 are sandwiched about an electrically insulating layer 24 of silicon dioxide. Primary body 20 normally has a light, substantially uniform doping of a P-type of N-type semiconductor impurity. For example, primary body 20 may be uniformly doped P-type with boron to a resistivity of 40 ohm-cm. Base wafer 22 may also be lightly doped P-type or N-type. The dopings in body 20 and wafer 22 have no significant effect on the thinning process of the invention.

Primary body 20 has a substantially uniform thickness of several microns, typically 3 microns. The upper surface 26 of body 20 is largely flat. In particular the standard deviation in planarity across upper surface 26-- i.e., the standard amount by which surface 26 differs from being completely planar -- is normally 0.2 - 0.3 micron. Base wafer 22 has a substantially uniform thickness of 600 - 650 microns, typically 625 microns.

Oxide layer 24 has a substantially uniform thickness of 0.8 - 1.2 microns, typically 1.0 micron. A thin native oxide layer (not shown in the drawings) usually lies along the upper surface of primary body 20. When present, the upper native oxide layer has a thickness of 20 - 40 angstroms formed by exposure of body 20 to the atmosphere. An electrically insulating layer 28 of silicon dioxide lies along the lower surface of base wafer 20. While oxide layer 28 may be a native oxide layer of 20 - 40 angstroms thickness, layer 28 normally is of approximately the same thickness as oxide layer 24.

Base wafer 22 and oxide layers 24 and 28 form a structure that has sufficient mass and mechanical strength to support primary body 20 during normal handling and IC fabrication operations, including the thinning steps performed to create the principal silicon layer in the present SOI structure.

Various processes may be employed to form the structure depicted in Fig. 2a. For example, if oxide layer 28 is a native oxide layer, the structure may be fabricated in largely the way described above for the prior art structure of Fig. 1d. If oxide layer 28 is of approximately the same thickness as oxide layer 24, the structure of Fig. 2a may be created in the way described above for the structure of Fig. 1d except that oxide layers 14 and 16 are formed along base wafer 12 rather than primary wafer 10. The method used to form the structure in Fig. 2a is not particularly relevant as long as the structure has the flatness and structural characteristics indicated above.

Using a suitable gaseous chemical etchant, a vapor-phase etch which has a well-controlled material removal rate is performed on the structure starting from surface 26 to reduce the thickness of primary body 20 in a substantially uniform manner to a value of 1 micron or less. The vapor phase etch is terminated when a selected etch time is reached, without relying on an etch stop created in body 20. Surface 26 is thereby lowered to produce the final SOI structure shown in Fig. 2b while remaining largely flat. Body 20 in Fig. 2b constitutes the principal silicon layer in the SOI structure.

For a vapor-phase etch of 1 - 2 microns (.e.g., etching primary body 20 from an initial average Si thickness of about 2 - 3 microns to a final average Si thickness of about 1 micron), the standard deviation in the etch uniformity -- i.e., the standard amount by which the amount of removed silicon differs from being exactly the same across all of upper surface 26-- is normally several hundredths of a micron. This is considerably smaller than the pre-etch standard deviation in planarity of 0.2 - 0.3 micron across surface 26. Consequently, the planarity of surface 26 after the etch is nearly the same as before the etch.

The vapor-phase etchant preferably is gaseous hydrochloric-acid using hydrogen as carrier gas. The etch is preferably done at atmospheric pressure in the silicon deposition chamber of an epitaxial silicon chemical vapor deposition system such as the AMT 7600 or AMT 7800 reactor system made by Applied Materials Inc. The Si etch rate is controlled as a function of the HCl flow rate and etch (i.e., structure) temperature. More precisely, the Si etch rate $ER_{Si}$ in microns/minute varies approximately with etch temperature T in °C and HCl flow rate F in liters/minute according to the relationship:

$$(ER_{Si})^{1/2} = -0.1636F + 0.0002FT$$

as described in Medernach et al, "Characterization of the In Situ HCl Etch for Epitaxial Silicon", Emerging Semicon. Tech., Jan. 1986, pp. 79 - 92.

The etch temperature and HCl flow rate are adjusted to give a silicon etch rate of 0.01 - 0.30 micron/minute, preferably 0.07 - 0.15 micron/minute. For this purpose, the etch temperature is 1,100 - 1,200°C, preferably 1,150°C. Similarly, the HCl flow rate is 3 - 5 liters/minute, preferably 4 liters/minute. Also the $H_2$ flow rate is 40 - 80 liters/minute, preferably 60 liters/minute.

The etch time depends on the Si thickness to be removed from primary body 20. For the case in which approximately 2 microns of silicon are removed, the etch time range that corresponds to the preceding etch rate range is 6 - 200 minutes, preferably 13 - 20 minutes.

In a typical embodiment staring with a thickness of 3 microns for primary body 20, the vapor-phase etch is initiated by placing the structure of Fig. 2a, along with a number of other such structures, in the epitaxial silicon deposition chamber. Hydrogen is introduced into the chamber at a flow rate of 100 liters/minute as the etch temperature is raised to 1,150°C in several minutes. During this short hydrogen bake, the native oxide layer (again not shown) along upper surface 26 is removed.

Using hydrogen as carrier gas, with the $H_2$ flow rate cut down to 60 liters/minute, gaseous hydrochloric acid is introduced into the chamber at 4 liters/minute for 13 minutes. The exposed silicon is thereby etched at a rate of 0.15 micron/minute to reduce the thickness of body 20 to approximately 1 micron. After the HCl flow is turned off, the temperature is reduced under $H_2$ flow. Finally, the $H_2$ flow is turned off, and the structures are all removed from the chamber.

Tests were performed on 100-millimeter diameter structures of the foregoing type fabricated according to the second-mentioned bonded-wafer procedure to assess the etch uniformity achieved in removing approximately 1 micron of silicon with gaseous hydrochloric acid. These bonded-wafer structures all had an extremely low initial defect density in primary body 20. In the tests, the etch was done for 10 minutes at a rate of approximately 0.10 micron/minute. The etch temperature was 1,150°C. The HCl and $H_2$ flow rates were at the values given in the preceding paragraph.

Thickness measurements were taken at five points on each bonded-wafer test structure. The table below gives the test results for two SOI wafer test structures in terms of (a) the initial thickness $t_I$ of primary body 20 at the beginning of the vapor-phase etch, (b) the final thickness $t_F$ of principal Si layer 20 at the end of the etch, and (c) the amount etched $\Delta t$:

|  |  | $t_I$ (microns) | $t_F$ (microns) | $\Delta t$ (microns) |
|---|---|---|---|---|
| Structure 1 - Point | A | 3.39 | 2.42 | .97 |
|  | B | 3.14 | 2.19 | .95 |
|  | C | 3.06 | 2.08 | .98 |
|  | D | 2.94 | 1.96 | .98 |
|  | E | 3.28 | 2.36 | .92 |
| Structure 2 - Point | A | 3.37 | 2.39 | .98 |
|  | B | 2.89 | 1.93 | .96 |
|  | C | 2.99 | 1.95 | 1.04 |
|  | D | 2.75 | 1.81 | .94 |
|  | E | 2.71 | 1.79 | .92 |

In the preceding data, the average sample standard deviation in $t_I$ -- i.e., the average pre-etch standard deviation in planarity across upper surface 26 -- was about 0.22 micron. The average sample deviation in $\Delta t$ -- i.e., the average standard deviation in the etch uniformity across surface 26 -- was about 0.03 micron. This is quite small compared to the average sample deviation in $t_I$ and demonstrates the usefulness of the invention in producing SOI structures having very thin principal silicon layers. Also, the final defect density in the principal silicon layer of each of these structures was very close to the extremely low initial value.

To assess the etch accuracy in achieving $t_f$ considerably less than 1 micron, the vapor-phase etch was experimentally performed on a special initial SOI structure in which the planarity of upper surface 26 prior to the etch was extremely high. In particular, the sample standard deviation in $t_I$ was about 0.01 micron in the special structure.

In forming the special initial structure, a thin polycrystalline silicon ("polysilicon") layer was first created on a silicon-dioxide layer situated along most of one of the surfaces of a 100-millimeter diameter monosilicon semiconductive wafer. Using a seeded-growth technique, the polysilicon was then converted into a monosilicon layer that served as primary body 20 of Fig. 2a. At this point, $t_I$ for body 20 was nearly 2.0 microns. Due to the polycrystalline-to-monocrystalline conversion process, the initial defect density in body 20 of this structure was very high.

The vapor-phase etch was done with gaseous HCl in $H_2$ for 19 minutes at 0.075 micron/minute to remove about 1.4 microns of silicon along surface 26 in the special structure. As a consequence, $t_f$ was about 0.6 micron. The standard deviation in the etch uniformity was about 0.30 micron, again a very good low value. However, the high silicon defect density in primary body 20 of this structure was not significantly reduced during the etch.

In a typical application of the SOI structure depicted in Fig. 2b, a (web-like) dielectric region is created all the way through final Si layer 20 down to oxide layer 24 by a general MOS version of the well-known LOCOS technique so as to define a group of monosilicon pockets laterally separated from one another by material of the dielectric region. Source/drain zones of MOS-type FETs are then formed in the silicon pockets.

The present technique enables the thinning of primary body 20 from 2 - 3 microns to 1 micron or less to be done in a single step using standard semiconductor fabrication chemicals and equipment. The vapor-phase etch is easily controlled to provide a high etch uniformity. The invention is particularly suitable for volume wafer production.

While the invention has been described with reference to particular embodiments, this description is solely for the purpose of illustration and is not to be construed as limiting the scope of the invention claimed below. For example, the vapor-phase etch could be performed at a pressure as low as 1 torr in a low- pressure epitaxial silicon deposition reactor. The initial structure of Fig. 2a could be created from something other than a bonded-wafer structure. Various modifications and applications may thus be made by those skilled in the art without departing from the true scope and spirit of the invention as defined in the appended Claims.

**Claims**

1. A method of creating a semiconductor-on-insulator structure from an initial structure in which a primary wafer-like semiconductive body adjoins an electrically insulating layer of a substructure having sufficient mass and mechanical strength to support the primary body during normal handling and semiconductor device fabrication operations, the primary body having a largely flat major surface situated generally opposite the insulating layer, which method is characterized in that a vapor-phase etch is performed on the primary body starting from the major surface to thin the primary body and lower the major surface while keeping the major surface largely flat, the vapor-phase etch being performed without utilizing an etch stop situated in the initial structure.

2. A method as claimed in Claim 1, characterized in that the vapor-phase etch is done with gaseous hydrochloric acid.

3. A method as claimed in Claim 1, characterized in that the primary body is of substantially uniform composition prior to the vapor-phase etch.

4. A method as claimed in Claim 1, characterized in that the primary body has a thickness that is substantially uniform before the vapor-phase etch and is also substantially uniform after the vapor-phase etch.

5. A method as claimed in Claim 4, characterized in that the thickness of the primary body is at least 2 microns before the vapor-phase etch and is less than 2 microns afterwards.

6. A method as claimed in Claim 1, characterized in that the primary body consists substantially of monocrystalline semiconductor material.

7. A method as claimed in Claim 6, characterized in that the semiconductive material is silicon.

8. A method as claimed in Claim 7, characterized in that the vapor-phase etch is performed with gaseous hydrochloric acid using hydrogen as carrier gas.

9. A method as claimed in Claim 8, characterized in that the vapor-phase etch is done at a silicon etch rate of 0.01 - 0.30 micron/minute.

10. A method as claimed in Claim 9, characterized in that the etch is performed at a temperature between 1,100 and 1,200°C, the hydrochloric acid is employed at a flow rate between 3 to 5 liters/minute, and the hydrogen carrier gas is employed at a flow rate of between 40 to 80 liters/minute.

FIG. 1

FIG.2